# FASCICULE DE BREVET EUROPEEN

(11) **EP 2 795 718 B1**
(45) Date de publication et mention de la délivrance du brevet: **25.11.2015**
(21) Numéro de dépôt: 12816058.7
(22) Date de dépôt: 21.12.2012
(51) Int. Cl.: H01P 5/08

(54) **DISPOSITIF DE PROTECTION ÉLECTROMAGNÉTIQUE APTE À PROTÉGER UNE LIAISON HYPERFRÉQUENCES ENTRE UN CONNECTEUR ET UN ÉLÈMENT HYPERFRÉQUENCES**
ELEKTROMAGNETISCHE SCHUTZVORRICHTUNG ZUR PROJEKTION EINER MIKROWELLENVERBINDUNG ZWISCHEN EINEM STECKER UND EINEM MIKROWELLENELEMENT
ELECTROMAGNETIC PROTECTION DEVICE ABLE TO PROJECT A MICROWAVE CONNECTION BETWEEN A CONNECTOR AND A MICROWAVE ELEMENT

(30) Priorité: 23.12.2011 FR 1104078
(43) Date de publication de la demande: 29.10.2014
(73) Titulaire: THALES, 92400 Courbevoie (FR)
(72) Inventeur: LE BERRE, Jean-Paul, F-29238 Brest Cedex 3 (FR); PREDON, Eric, F-29238 Brest Cedex 03 (FR); HULIN, Pierre-yves, F-29238 Brest Cedex 3 (FR); BODENESE, Michel, F-29238 Brest Cedex 03 (FR)
(74) Mandataire: Lucas, Laurent Jacques
(86) Numéro de dépôt international: PCT/EP2012/076728
(87) Numéro de publication internationale: WO 2013/093038

(56) Documents cités:
- JP-A- 55 086 204
- JP-A- 61 100 004
- JP-A- 2003 347 468
- MARIAN L MAJEWSKI ET AL: "Modeling and Characterization of Microstrip-to-Coaxial Transitions", IEEE TRANSACTIONS ON MICROWAVE THEORY AND TECHNIQUES, IEEE SERVICE CENTER, PISCATAWAY, NJ, US, vol. MTT-29, no. 8, 1 août 1981 (1981-08-01), pages 799-805, XP001366238, ISSN: 0018-9480

## Description

La présente invention concerne le domaine des circuits hyperfréquences large bande placés dans un boîtier. La présente invention concerne plus particulièrement un dispositif de protection électromagnétique apte à protéger une liaison hyperfréquences entre un connecteur et un élément hyperfréquences placé dans un boîtier.

La présente invention trouve son utilité dans les boîtiers de circuit hyperfréquences large bande allant de quelques mégahertz à plusieurs dizaines de gigahertz.

Dans le domaine hyperfréquence et plus particulièrement avec les hautes fréquences comme par exemple des fréquences de l'ordre du gigahertz les liaisons électriques non protégées se comportent comme des antennes et sont susceptibles de capter différents parasites présents à l'intérieur du boîtier. Ces parasites sont ensuite transmis aux circuits et viennent perturber le bon fonctionnement de ces circuits hyperfréquences.

De façon à normaliser et protéger une liaison hyperfréquences entre un connecteur et un élément de circuit disposé sur un substrat diélectrique, il est connu de réaliser un cylindre, ou canon, par usinage dans la masse du boîtier autour d'un connecteur hyperfréquences. Un inconvénient de ce dispositif est sa rigidité. De ce fait, les contacts mécanique et électrique dépendent de l'application de plusieurs séquences de serrage à des couples de serrage supérieurs au standard ainsi que de l'utilisation d'un outillage spécialisé. De plus un appairage de la structure comportant le ou les canons et de son capot est nécessaire.

Par ailleurs, ce montage hyperstatique ne convient pas à un usage dans des conditions d'environnement sévères comme par exemple pour une application aéroportée.

L'invention a notament pour but de corriger les inconvénients précités. Ce but est atteint par un dispositif de protection électromagnétique apte à protéger une liaison hyperfréquences entre un connecteur hyperfréquences placé sur un boîtier et au moins un élément d'un circuit hyperfréquences contenu dans ledit boîtier, le dispositif étant formé d'une pièce rapportée réalisée en matériau élastique électriquement conducteur et assurant la continuité de masse entre la masse électrique du circuit hyperfréquence et la masse mécanique du boîtier et du capot.

Selon une particularité de l'invention, le dispositif est formé d'un tube réalisé en alliage de cuivre recuit.

Selon une autre particularité, le dispositif est réalisé en Cuivre Béryllium CuBe2.

De façon avantageuse, un traitement par dorage est réalisé sur la surface extérieure du dispositif.

Dans un mode de réalisation, l'impédance caractéristique du dispositif est égale à celle du connecteur et celle de l'élément du circuit hyperfréquence.

Selon une variante de réalisation, l'impédance caractéristique du dispositif est normalisée à 50 Ohms.

Dans un autre mode de réalisation, le diamètre intérieur du dispositif est égal à 1,73 millimètres et son diamètre extérieur est de 1,93 millimètres.

Un autre but de l'invention est de proposer un procédé de mise en oeuvre du dispositif selon l'invention. Ce but est atteint par un procédé comportant :
- une étape d'usinage d'un trou débouchant dans la paroi du boîtier à traverser dont la section est sensiblement égale à celle de la section du dispositif de protection,
- une étape de passage du dispositif àtravers la paroi du boîtier,
- une étape de fixation du connecteur sur la paroi du boîtier,
- et une étape de passage de la liaison dans le dispositif de protection électromagnétique.

L'invention décrite précédemment a pour principal avantage, comparée aux systèmes habituellement utilisés :
- de simplifier le processus actuel en absorbant les écarts de tolérances de fabrication et de montage des pièces mécaniques (structure, capot) et en le rendant moins dépendant notamment des dispersions de tolérances du circuit imprimé, mécaniques et capots.
- de permettre d'obtenir un contact mécanique et électrique facilité du fait des propriétés élastiques du nouveau dispositif, ce qui simplifie fortement le processus de serrage du capot sur la structure grâce à un serrage standard des vis sans utilisation d'outillage spécial,
- d'éviter que les démontages successifs du capot hyperfréquence durant les phases de réglages et de tests n'altèrent les performances électriques,
- d'éviter l'appairage du capot hyper avec la structure,
- de réduire le prix de revient de la fonction.

D'autres particularités et avantages de la présente invention apparaîtront plus clairement à la lecture de la description ci-après, donnée à titre illustratif et non limitatif, et faite en référence aux dessins annexés, dans lesquels :
- La figure 1 représente un exemple de réalisation du dispositif de protection antérieur à l'invention.
- La figure 2 représente un exemple de réalisation du dispositif de protection suivant l'invention.

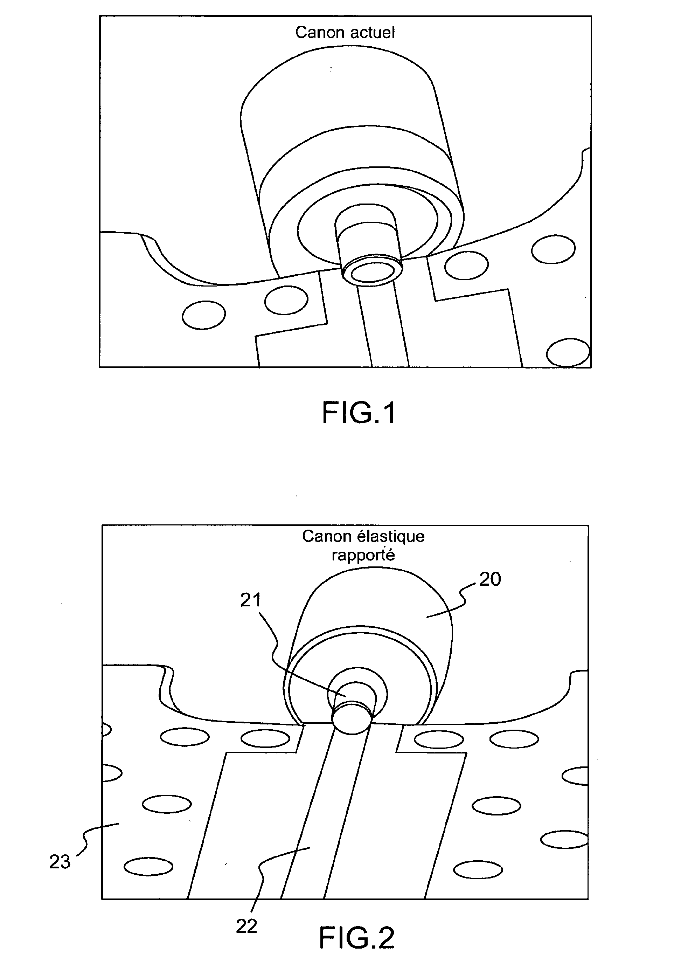

En référence à la figure 2, le dispositif de protection 20 suivant l'invention est formé d'un tube en métal élastique conducteur comme par exemple un alliage de cuivre. De façon à augmenter l'élasticité du matériau, l'alliage du cuivre est de façon préférentielle recuit. Suivant un exemple de réalisation, le tube est de forme sensiblement cylindrique. Suivant un mode de réalisation particulier, le dispositif de protection 20 est réalisé en cuivre béryllium.

De façon avantageuse, l'élasticité du matériau permet d'absorber les écarts de tolérances de fabrication et de montage des différentes pièces mécaniques comme par exemple le boîtier, son capot ainsi que celles du circuit imprimé.

Un rôle de ce dispositif 20 est d'assurer une protection électromagnétique autour de la liaison 21 entre un connecteur hyperfréquences et le circuit hyperfréquences. Il permet également d'assurer, en association avec le capot, une continuité de transmission à forte immunité. Cette liaison 21 peut, par exemple, être l'âme centrale du connecteur. Il est à noter que le dispositif selon l'invention est une pièce rapportée indépendante du connecteur hyperfréquences. Le dispositif peut être assimilé à un canon de blindage à l'intérieur du boîtier. L'isolation est assurée par la mise à la masse du dispositif. Cette mise à la masse est assurée par le serrage du capot du boîtier contre le dispositif de protection selon l'invention lors de la fermeture du boîtier. De façon avantageuse, l'élasticité du matériau utilisé pour réaliser le canon rapporté élastique permet de diminuer les forces de serrage des vis de fixation et ainsi utiliser un outillage standard. De plus le serrage standard des vis permet d'éviter la casse de ces dernières.

Le report de masse est également assuré entre le dispositif et sur toute la zone de contact entre le connecteur et le dispositif selon l'invention. La continuité entre la masse mécanique du dispositif et la masse électrique du circuit hyperfréquences est assuré par serrage du capot sur le dispositif 20. Le dispositif de protection assure ainsi une parfaite continuité entre les différentes masse à savoir la masse mécanique du boîtier et du capot, la masse électrique 23 du circuit hyperfréquences et celle du connecteur.

Suivant un mode de réalisation particulier, un traitement par dorage peut être appliqué sur la surface extérieure du dispositif 20. L'épaisseur du dorage est par exemple de l'ordre de 2 micromètres.

Un autre rôle de ce dispositif est de canaliser le signal hyperfréquence entre le connecteur et l'élément du circuit hyperfréquences placé à l'autre extrémité du dispositif. Un but du dispositif est de réaliser une liaison coaxiale entre ces deux éléments.

Dans certains modes de réalisation l'âme du connecteur 21 est soudée sur une piste 22 de circuit hyperfréquence. Sur le connecteur hyperfréquence, le signal est transmis en mode coaxial. Sur la piste 22 du circuit hyperfréquences le signal est transmis suivant un mode microruban ou microstrip selon le terme anglo-saxon. Au niveau de la liaison on a donc un passage entre deux modes de transmission différents. Afin de ne pas perturber la transmission du signal et ainsi éviter les problèmes d'ondes stationnaires, les différentes dimensions du canon rapporté 20 peuvent être choisies de façon à ce que l'impédance caractéristique du dispositif 20 soit normalisée. L'impédance normalisée du dispositif permet également de s'affranchir des problèmes de rupture d'impédance dans le cas général de liaison entre un connecteur et un élément de circuit hyperfréquences.

Selon un exemple de réalisation nullement limitatif, le dispositif 20 est formé d'un cylindre creux avec un bord dont le diamètre extérieur mesure 1,93 millimètres et le diamètre intérieur 1,73 millimètres. Ces différentes cotes permettent au dispositif selon l'invention d'avoir une impédance caractéristique de 50 Ohms. Dans certains modes de réalisation le dispositif 20 mesurera 3 millimètres de long.

Le dispositif 20 selon l'invention peut être réalisé par emboutissage ou par usinage par exemple par décolletage.

Le dispositif selon l'invention forme un dispositif de liaison hyperfréquences normalisée entre un connecteur et un élément hyperfréquences, comme par exemple un circuit imprimé, à forte isolation radioélectrique.

Un mode de mise en oeuvre du dispositif 20 peut consister à placer le dispositif avant de placer le connecteur sur le boîtier. Dans une première étape un trou débouchant est usiné dans la paroi du boîtier à traverser dont la section est sensiblement égale à celle de la section du dispositif de protection. Ledit dispositif est ensuite glissé à travers la paroi du boîtier, par exemple de l'extérieur du boîtier vers l'intérieur, la face intérieure de la paroi correspondant à la face en vis-à-vis de l'élément hyperfréquence et la face extérieur à la face opposée. Le dispositif 20 peut être monté serré ou collé à la paroi, par exemple à l'aide de colle conductrice. Le connecteur est ensuite fixé à la paroi du boîtier et la liaison 21 comme par exemple l'âme centrale du connecteur est ensuite introduite à l'intérieur du dispositif 20. Bien entendu la mise en oeuvre de l'invention ne se limite pas à ce mode et tout mode équivalent peut convenir.

De façon avantageuse, les qualités mécaniques d'élasticité et de reproductibilité du dispositif de protection électromagnétique selon l'invention peut permettre une utilisation en milieu sévère comme par exemple dans le domaine aéroporté militaire et le domaine civil.

## Revendications

1. Dispositif de protection électromagnétique 20 apte à protéger une liaison hyperfréquence 21 entre un connecteur hyperfréquences placé sur un boîtier et au moins un élément d'un circuit hyperfréquences contenu dans ledit boîtier **caractérisé en ce qu'**il est formé d'un tube rapporté, assurant la continuité de masse entre la masse électrique du circuit hyperfréquence et la masse mécanique du boîtier et du capot, ledit dispositif étant réalisé en alliage de cuivre recuit et traité par dorage, dont le diamètre interrieur est dimentionné de façon à ce que l'impédance caractéristique du tube soit égale à celle du connecteur et celle de l'élément du circuit hyperfréquences

2. Dispositif 20 suivant la revendication précédente **caractérisé en ce qu'**il est réalisé en Cuivre Béryllium CuBe2.

3. Dispositif 20 suivant une des revendications précédentes **caractérisé en ce qu'**un traitement par dorage est réalisé sur sa surface extérieure.

4. Dispositif 20 suivant une des revendications précédentes **caractérisé en ce que** son impédance caractéristique est normalisée à 50 Ohms.

5. Dispositif suivant une des revendications précédentes **caractérisé en ce que** son diamètre intérieur est égal à 1,73 millimètres et son diamètre extérieur est de 1,93 millimètres.

6. Procédé de mise en oeuvre d'un dispositif de protection 20 selon une des revendications 1 à 5 **caractérisé en ce qu'**il comprend :
- une étape d'usinage d'un trou débouchant dans la paroi du boîtier à traverser dont la section est sensiblement égale à celle de la section du dispositif de protection 20,
- une étape de passage du dispositif à travers la paroi du boîtier,
- une étape de fixation du connecteur sur la paroi du boîtier,
- une étape de passage de la liaison 21 dans le dispositif de protection éléctromagnétique

## Patentansprüche

1. Elektromagnetische Schutzvorrichtung 20 zum Schützen einer Mikrowellenverbindung 21 zwischen einem auf einem Gehäuse platzierten Mikrowellenverbinder und wenigstens einem Element einer in dem Gehäuse enthaltenen Mikrowellenschaltung, **dadurch gekennzeichnet, dass** sie aus einem Aufsatzrohr gebildet ist, das die Massekontinuität zwischen der elektrischen Masse der Mikrowellenschaltung und der mechanischen Masse des Gehäuses und des Deckels gewährleistet, wobei die Vorrichtung aus einer geglühten Kupferlegierung hergestellt und vergoldet ist, wobei ihr Innendurchmesser so dimensioniert ist, dass die charakteristische Impedanz des Rohrs gleich der des Verbinders und der des Elements der Mikrowellenschaltung ist.

2. Vorrichtung 20 nach dem vorherigen Anspruch, **dadurch gekennzeichnet, dass** sie aus Berylliumkupfer CuBe2 hergestellt ist.

3. Vorrichtung 20 nach einem der vorherigen Ansprüche, **dadurch gekennzeichnet, dass** eine Vergoldungsbehandlung auf ihrer Außenfläche durchgeführt wird.

4. Vorrichtung 20 nach einem der vorherigen Ansprüche, **dadurch gekennzeichnet, dass** ihre charakteristische Impedanz auf 50 Ohm normalisiert ist.

5. Vorrichtung nach einem der vorherigen Ansprüche, **dadurch gekennzeichnet, dass** ihr Innendurchmesser gleich 1,73 Millimeter und ihr Außendurchmesser 1,93 Millimeter ist.

6. Verfahren zum Betrieb einer Schutzvorrichtung 20 nach einem der Ansprüche 1 bis 5, **dadurch gekennzeichnet, dass** es Folgendes beinhaltet:
einen Schritt des Einarbeitens eines Lochs, das in der Wand des zu durchquerenden Gehäuses mündet, dessen Querschnitt im Wesentlichen gleich dem des Querschnittes der Schutzvorrichtung 20 ist,
einen Schritt des Durchführens der Vorrichtung durch die Wand des Gehäuses,
einen Schritt des Befestigens des Verbinders an der Wand des Gehäuses,
einen Schritt des Durchführens der Verbindung 21 in der elektromagnetischen Schutzvorrichtung.

## Claims

1. Electromagnetic protection device 20 which is capable of protecting a hyperfrequency connection 21 between a hyperfrequency connector which is placed on a casing and at least one element of a hyperfrequency circuit which is contained in the casing, **characterised in that** it is formed by an attached tube which ensures the continuity of earth between the electrical earth of the hyperfrequency circuit and the mechanical earth of the casing and the cover, the device being produced from a copper alloy which is annealed and processed by means of gold plating and whose inner diameter is sized so that the characteristic impedance of the tube is equal to that of the connector and that of the element of the hyperfrequency circuit.

2. Device 20 according to the preceding claim, **characterised in that** it is produced from copper beryllium CuBe2.

3. Device 20 according to either of the preceding claims, **characterised in that** a processing operation by means of gold plating is carried out on the outer surface thereof.

4. Device 20 according to any one of the preceding claims, **characterised in that** the characteristic impedance thereof is standardised at 50 Ohms.

5. Device according to any one of the preceding claims, **characterised in that** the inner diameter thereof is 1.73 millimetres and the outer diameter thereof is 1.93 millimetres.

6. Method for implementing a protection device 20 according to any one of claims 1 to 5, **characterised in that** it comprises:
a step of producing a hole which opens in the wall of the casing to be passed through and whose cross-section is substantially equal to that of the cross-section of the protection device 20,
a step of passing the device through the wall of the casing,
a step of fixing the connector to the wall of the casing,
a step of passing the connection 21 into the electromagnetic protection device.
